# DEMANDE DE BREVET EUROPEEN

(11) **EP 1 947 210 A1**
(43) Date de publication de la demande: **23.07.2008**
(21) Numéro de dépôt: 07290054.1
(22) Date de dépôt: 16.01.2007
(51) Int. Cl.: C23C 14/24, C23C 14/56

(54) **Procede de revetement d'un substrat, installation de mise en oeuvre du procede et dispositif d'alimentation en metal d'une telle installation**

(71) Demandeur: ARCELOR France, 93200 Saint Denis (FR)
(72) Inventeur: Chaleix, Daniel, 57420 Verny (FR); Jacques, Daniel, 57100 Thionville (FR); Sponem, Florent, 57190 Florange (FR)
(74) Mandataire: Plaisant, Sophie Marie

(57) **Abrégé**

L'invention concerne un procédé de revêtement d'au moins une face d'un substrat en défilement, par évaporation sous vide d'une couche de métal ou d'alliage métallique susceptible d'être sublimé, selon lequel le métal ou alliage métallique est disposé en regard de la face du substrat sous la forme d'au moins deux lingots placés en contact l'un avec l'autre, la surface des lingots tournée vers ladite face du substrat étant maintenue parallèle au substrat et à une distance constante de celui-ci, au cours du revêtement, ainsi qu'une installation de revêtement pour la mise en oeuvre du procédé et un dispositif d'alimentation en métal (1) pour une telle installation.

## Description

La présente invention concerne un procédé de revêtement de substrat en défilement, plus particulièrement destiné au revêtement de bandes d'acier par des couches à base d'éléments métalliques, tels que le magnésium par exemple, sans pour autant y être limitée.

On connaît différents procédés permettant de déposer sur un substrat en défilement, telle qu' une bande d'acier, des revêtements métalliques composés d'une couche de métal, de plusieurs couches successives de différents métaux, ou bien encore d'alliages métalliques. Parmi celles-ci, on pourra citer la galvanisation au trempé à chaud, l'électrodéposition ou bien encore les différents procédés de dépôt sous vide (sputtering magnétron, évaporation par effet joule, par bombardement électronique et par plasma auto-induit encore appelé SIP).

Les procédés de dépôt sous vide présentent l'avantage d'être respectueux de l'environnement et de permettre de déposer virtuellement tous les éléments connus, mais également des alliages. Lorsque l'on souhaite procéder au dépôt en continu d'une couche métallique sur un substrat en défilement, se pose alors le problème de l'alimentation de l'enceinte de dépôt en métal à déposer.

On connaît un premier type d'installations de revêtement dans lequel le métal à déposer est maintenu sous forme liquide par fusion dans un four puis est acheminé vers la zone de dépôt au moyen d'une pompe par exemple, ou bien encore par le principe du baromètre. Ce type d'installation n'est cependant pas adapté au dépôt d'éléments métalliques qui se subliment, c'est à dire qui passent directement de la phase solide à la phase gazeuse.

On connaît également un second type d'installations de revêtement dans lequel le métal à déposer est sous forme solide, comme par exemple sous forme de fils que l'on introduit de façon régulière, ou bien encore sous forme de granules que l'on place à l'intérieur d'un creuset inerte en graphite. Ces installations permettent le dépôt d'éléments métalliques qui se subliment, mais le procédé de dépôt présentent des instabilités générant des épaisseurs de revêtement non homogènes au cours du temps, ainsi qu'une limitation de la puissance de chauffage, qui ne permet pas d'atteindre des vitesses de dépôt suffisantes.

Le but de la présente invention est donc de remédier aux inconvénients des procédés de l'art antérieur en mettant à disposition un procédé de fabrication d'un substrat en défilement par un métal ou un alliage métallique sublimable qui permette un fonctionnement stable dans le temps à une vitesse de dépôt élevée.

A cet effet, un premier objet de la présente invention est constitué par un procédé de revêtement d'au moins une face d'un substrat en défilement, par évaporation sous vide d'une couche de métal ou d'alliage métallique susceptible d'être sublimé, selon lequel ledit métal ou alliage métallique est disposé en regard de ladite face du substrat sous la forme d'au moins deux lingots placés en contact l'un avec l'autre, la surface desdits lingots tournée vers ladite face du substrat étant maintenue parallèle au substrat et à une distance constante de celui-ci, au cours du revêtement.

Le procédé selon l'invention peut également comprendre différentes caractéristiques, prises seules ou en combinaison :
- les lingots de métal ou d'alliage métallique susceptible d'être sublimé peuvent être déplacés simultanément, de façon continue ou séquentielle, afin de maintenir leurs surfaces tournées vers le substrat parallèles et à distance constante de celui-ci,
- les lingots de métal ou d'alliage métallique susceptible d'être sublimé peuvent être déplacés simultanément par translation,
- les lingots peuvent être déplacés simultanément par translation dans un plan parallèle au plan de défilement du substrat et dans une direction perpendiculaire à la direction de défilement du substrat, la surface des lingots opposée à celle tournée vers le substrat étant en contact avec un plan incliné,
- les lingots peuvent être déplacés simultanément par translation dans un plan parallèle au plan de défilement du substrat et dans une direction parallèle à la direction de défilement du substrat, la surface des lingots opposée à celle tournée vers le substrat étant en contact avec un plan incliné,
- le substrat peut défiler en position verticale, les lingots étant empilés l'un sur l'autre,
- on peut revêtir le substrat sur ses deux faces par évaporation sous vide d'une couche de métal ou d'alliage métallique susceptible d'être sublimé, le métal ou alliage métallique étant disposé en regard de chaque face du substrat sous la forme d'au moins deux lingots placés en contact l'un avec l'autre, la surface des lingots tournée vers chaque face du substrat étant maintenue parallèle et à distance constante de la face du substrat, au cours du revêtement,
- le métal ou alliage métallique peut être identique ou différent pour chaque face du substrat,
- le procédé d'évaporation sous vide peut être un procédé de dépôt par évaporation par plasma auto-induit (SIP).
- le métal ou alliage métallique peut être choisi parmi le zinc, le magnésium, le chrome, le manganèse, le silicium et leurs alliages et est de préférence du magnésium ou un de ses alliages,
- le dépôt par évaporation sous vide peut être effectué dans une atmosphère réactive,
- le substrat en défilement peut être une bande d'acier, éventuellement déjà revêtue au préalable et de préférence, une bande d'acier préalablement revêtue de zinc ou d'alliage de zinc et sur laquelle on dépose une couche de magnésium ou d'alliage de magnésium.

Un second objet de l'invention est constitué par une installation de revêtement en continu d'un substrat S sur au moins une de ses faces par une couche d'un métal ou d'un alliage métallique susceptible d'être sublimé, comprenant une enceinte sous vide contenant :
- un dispositif de revêtement par évaporation sous vide,
- des moyens de défilement dudit substrat S au sein du dispositif de revêtement,
- un dispositif d'alimentation 1, 11, 21 en métal ou alliage métallique du dispositif de revêtement, ledit métal ou alliage métallique se présentant sous la forme de lingots L1, ..., Ln, L'1, ..., L'n et comprenant des moyens permettant de maintenir les lingots L1, ..., Ln, L'1, ..., L'n en contact les uns avec les autres et de maintenir la surface des lingots L1, ..., Ln, L'1, ..., L'n tournée vers la face à revêtir du substrat S, parallèle et à distance constante du substrat S.

L'installation selon l'invention peut également comprendre les variantes suivantes, prises isolément ou en combinaison :
- le dispositif d'alimentation 1, 11, 21 peut comprendre des moyens permettant de déplacer simultanément les lingots L1, ..., Ln, L'1, ..., L'n de façon séquentielle ou continue afin de maintenir leurs surfaces tournées vers le substrat S parallèles et à distance constante de celui-ci,
- le dispositif d'alimentation 11 peut comprendre au moins un plan incliné 2, 2' avec lequel les lingots L1, ..., Ln, L'1, ..., L'n sont en contact par leur face opposée à celle tournée vers le substrat S, les moyens de déplacement des lingots L1, ..., Ln, L'1, ..., L'n permettant de les déplacer par translation dans un plan parallèle au plan de défilement du substrat S et dans une direction perpendiculaire à la direction de défilement du substrat S et le plan incliné 2, 2' présentant une inclinaison augmentant dans la direction de déplacement des lingots L1, ..., Ln, L'1, ..., L'n,
- les moyens de déplacement des lingots L1, ..., Ln, L'1, ..., L'n peuvent être constitués par au moins un piston 3, 3' agissant sur un premier lingot L1, L'1 en contact avec une première extrémité du plan incliné 2, 2', et s'étendant transversalement par rapport au substrat S, le premier lingot L1, L'1 agissant à son tour sur les lingots L2, ..., Ln, L'2, ..., L'n le précédant sur ledit plan incliné 2, 2' jusqu'à sa seconde extrémité,
- l'installation peut comprendre un premier plan incliné 2 muni de lingots L1, ..., Ln et d'un premier piston 3 agissant sur le premier lingot L1 en contact avec la première extrémité du premier plan incliné 2 et un second plan 2' incliné muni de lingots L'1, ..., L'n et d'un second piston 3' agissant sur le premier lingot L'1 en contact avec la première extrémité du second plan incliné 3', lesdits pistons 3, 3' pouvant agir dans la même direction ou dans des directions contraires,
- l'installation peut comprendre deux bacs 4 de récupération par gravité des lingots usagés U, placés sous chaque seconde extrémité des plans inclinés 2, 2',
- le dispositif d'alimentation 11, 21 peut comprendre au moins un plan incliné 12, 22 avec lequel les lingots L1, ..., Ln sont en contact par leur face opposée à celle tournée vers le substrat S, les moyens de déplacement des lingots permettant de les déplacer par translation dans un plan parallèle au plan de défilement du substrat S et dans une direction parallèle à la direction de défilement du substrat S et le plan incliné 12, 22 présentant une inclinaison augmentant dans la direction de déplacement des lingots L1, ..., Ln,
- les moyens de déplacement des lingots L1, ..., Ln peuvent être constitués par au moins un piston 13, 23 agissant sur un premier lingot L1 en contact avec une première extrémité du plan incliné 12, 22, et s'étendant longitudinalement par rapport au substrat S, le premier lingot L1 agissant à son tour sur les lingots L2, ..., Ln le précédant sur le plan incliné 12, 22 jusqu'à sa seconde extrémité,
- l'installation peut comprendre un bac de récupération par gravité des lingots usagés, placé sous la seconde extrémité du plan incliné 12, 22,
- le substrat S peut défiler en position verticale, le dispositif d'alimentation 21 comprenant au moins une plaque verticale 24 sur laquelle sont empilés les lingots L1, ..., Ln et qui est en contact avec au moins un piston vertical 23 en position verticale,
- l'installation peut comprendre un dispositif d'alimentation 1, 11, 21 en regard de chaque face du substrat S, chaque dispositif d'alimentation 1, 11, 21 pouvant contenir un métal ou un alliage métallique identique ou différent, ainsi qu'un dispositif d'évaporation sous vide en regard de chaque face du substrat S, l'ensemble étant placé au sein d'une même enceinte sous vide,
- l'installation peut comprendre des moyens d'introduction d'une atmosphère réactive au sein de l'enceinte sous vide,
- le ou les dispositifs d'évaporation sous vide peuvent être des dispositifs de dépôt par évaporation par plasma auto-induit SIP,
- les lingots L1, ..., Ln, L'1, ..., L'n de métal ou d'alliage métallique peuvent être choisis parmi le zinc, magnésium, le chrome, le manganèse et le silicium ou leurs alliages.

Un troisième objet de l'invention est constitué par un dispositif d'alimentation 1, 11, 21 en métal ou alliage métallique d'une installation de dépôt par revêtement sous vide, tel que défini ci-dessus.

D'autres caractéristiques et avantages de l'invention apparaîtront à la lecture de la description qui va suivre, donnée uniquement à titre d'exemple, en référence aux schémas annexés qui représentent :
- -figure 1 : vue en coupe d'un lingot métallique mis en oeuvre par un procédé selon l'art antérieur,
- figure 2 : vue en perspective d'un premier mode de réalisation d'une installation selon l'invention,
- figure 3 : vue en perspective d'un deuxième mode de réalisation d'une installation selon l'invention,
- figure 4 : vue en perspective d'un troisième mode de réalisation d'une installation selon l'invention.

Dans le cadre de la présente invention, on entend par procédé d'évaporation, tout procédé de dépôt par évaporation sous pression réduite par rapport à la pression atmosphérique. L'évaporation sera de préférence effectuée par le procédé SIP (self-induced plasma) dans lequel on combine évaporation sous vide et sputtering magnétron.

Ce procédé consiste à créer un plasma entre un substrat et un creuset contenant la matière à déposer, dans un gaz permettant de générer des radicaux et/ou ions. Ces ions vont, dans les conditions normales de fonctionnement, être accélérés vers la surface de la matière à déposer sur le substrat, et venir arracher des atomes superficiels qui se déposent ensuite sur le substrat. Dans le même temps, le bombardement des ions créés dans le plasma génère un échauffement de la matière à déposer permettant d'ajouter un processus d'évaporation en plus de la pulvérisation magnétron. On pourra notamment se référer au brevet EP 780 486 pour plus de précisions sur la mise en oeuvre de ce procédé.

Le substrat à revêtir se déplace dans une chambre sous vide en regard du creuset contenant la matière à déposer. Ce dernier est polarisé négativement par rapport au substrat, lui-même préférentiellement relié à la masse. Un ensemble d'aimants positionné à l'arrière du creuset confine le plasma créé auprès de celui-ci. Afin de positionner de façon très précise le substrat à revêtir par rapport au creuset, le substrat est généralement disposé sur un rouleau d'appui qui peut être mis en rotation autour de son axe. Ce type de rouleau n'est cependant pas nécessaire lorsque l'on traite des substrats sous forme de plaques rigides, telles que des tôles métalliques épaisses ou des plaques de verre.

Le procédé selon l'invention consiste donc à procéder au dépôt d'une couche métallique ou d'alliage métallique sur un substrat en défilement.

Il s'applique plus particulièrement, mais pas uniquement, au traitement de bandes d'acier, de préférence revêtues de zinc ou d'alliage de zinc. Par alliage de zinc, on désigne tout composé comprenant au moins 50% de zinc et pouvant contenir, par exemple, de l'aluminium, du fer, du silicium etc...

L'obtention de ce revêtement préalable pourra être fait par tout procédé connu de galvanisation, qu'il s'agisse de galvanisation au trempé à chaud, d'électrodéposition ou de dépôt par évaporation sous vide, par exemple. On préférera cependant les procédés de dépôt sous vide.

Le revêtement déposé dans le cadre de la présente invention est un revêtement métallique à base d'éléments susceptibles d'être sublimés lors de leur dépôt par évaporation sous vide. Cela recouvre en particulier des éléments tels que le zinc, le magnésium, le chrome, le manganèse et le silicium, à titre indicatif. On préfère en particulier déposer du magnésium sur une bande préalablement recouverte de zinc, à la suite de quoi on peut procéder à un traitement de diffusion par tout moyen approprié, afin d'obtenir en final un revêtement de Zn-Mg, présentant notamment des performances élevées en matière de résistance à la corrosion.

Les présents inventeurs ont tout d'abord procédé à des essais d'évaporation d'un lingot de magnésium massif et statique placé en regard d'une bande d'acier en défilement au sein d'une installation de dépôt sous vide par le procédé SIP.

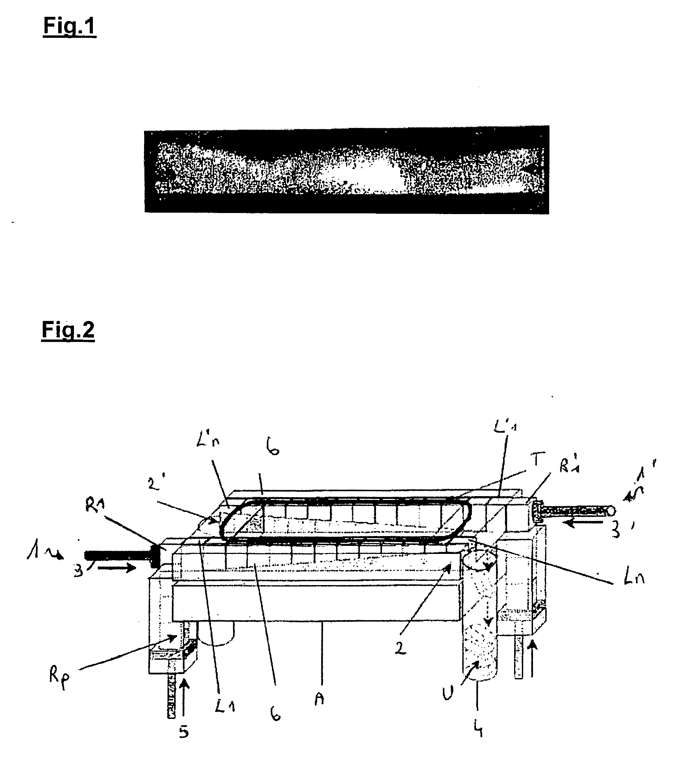

Au bout d'un certain temps d'exploitation, on observe que le dépôt ne présente pas une épaisseur homogène et que la vitesse de dépôt est relativement faible. Il a donc fallu interrompre le dépôt et il a été possible d'observer l'état du lingot, dont une représentation est reproduite en figure 1.

On peut constater que l'usure du lingot est très irrégulière et particulièrement accentuée au droit de la zone de fort champ magnétique. Sans vouloir être liés par une théorie, les présents inventeurs estiment que l'instabilité du procédé de dépôt est directement liée à l'irrégularité de l'usure du lingot.

Afin de stabiliser le procédé, les inventeurs ont donc divisé le lingot massif en au moins deux lingots et ont maintenu les faces supérieures de ces lingots parallèles et à distance constante du substrat à revêtir, en compensant de façon continue ou séquentielle l'usure due à l'évaporation.

A cet effet, une première installation de revêtement selon l'invention, par le procédé SIP, a été mise au point et est partiellement reproduite en figure 2, sur laquelle on peut voir un dispositif d'alimentation 1.

Celui-ci est placé sous le substrat à revêtir (non représenté) qui défile horizontalement, au-dessus du système d'aimants A de confinement du champ magnétique, qui sont placés dans une boîte à eau. Une contre-électrode (non représentée) est placée sous le dispositif d'alimentation 1 et un plasma est créé par décharge entre l'ensemble contre-électrode/aimants et la bande d'acier. Pour faciliter la compréhension, on a représente la zone d'érosion préférentielle au moyen d'un circuit T qui représente la zone de champ magnétique intense.

Le dispositif d'alimentation 1 comprend un premier plan incliné 2 dont l'inclinaison augmente de la gauche vers la droite. Ce plan incliné pourra être réalisé en tout matériau approprié, du moment que celui-ci n'est pas susceptible d'être pulvérisé lors de l'opération, ce qui viendrait polluer le revêtement obtenu. On pourra par exemple réaliser ce premier plan incliné 2 en tungstène.

Sur ce plan incliné 2, sont disposés une série de n lingots L1 à Ln, en contact les uns avec les autres et dont la hauteur va en décroissant de la gauche vers la droite. L'inclinaison du plan incliné 2 est adaptée pour compenser l'usure des lingots L1 à Ln, de telle sorte que les faces supérieures des lingots L1 à Ln restent parallèles entre elles et parallèles au substrat à revêtir qui défile au-dessus du dispositif 1, perpendiculairement au plan incliné 2. On maintient ainsi une distance constante entre les aimants et la surface des lingots, ainsi qu'une distance constante entre la surface des lingots et la face du substrat à revêtir.

De part et d'autre des lingots L1 à Ln, sont prévues deux guides latéraux 6 en tungstène qui maintiennent ces lingots L1 à Ln bien alignés.

A la gauche du premier lingot L1 est placé un piston 3 qui agit sur ce premier lingot L1 pour le déplacer en translation vers la droite, tout en étant guidé par le plan incliné 2 et le guide latéral 6. Le mouvement du lingot L1 déplace en cascade tous les lingots posés sur le plan incliné 2, jusqu'à ce que le lingot d'extrémité Ln tombe par gravité dans un bac de récupération 4 qui permet de réceptionner les lingots usagés qui pourront être fondus et réutilisés.

Lorsque l'extrémité du piston 3 arrive au niveau de la première extrémité du plan incliné 2, il est alors en bout de course et est actionné dans le sens inverse. Dans un second temps, un piston vertical 5 agissant sur une platine portant une série de p lingots neufs R1 à Rp, est actionné vers le haut, de façon à présenter un nouveau lingot à hauteur de la première extrémité du plan incliné 2. Le piston 3 est alors mis en contact avec la face latérale du lingot R1 qui est poussé contre le premier lingot L1 en contact avec le plan incliné 2.

On voit donc que l'on peut alimenter en lingots le dispositif, de façon continue, sans interruption du procédé et en maintenant la surface des lingots en exploitation à la fois plane et parallèle au substrat à revêtir grâce au plan incliné 2 et au mouvement régulier imprimé par le piston 3.

Afin de couvrir la majeure partie de la zone de champ magnétique intense T et donc d'optimiser la vitesse de dépôt, on a placé un second dispositif d'alimentation 1' en tous points identique au dispositif 1, au regard de le seconde moitié de la zone T. Le piston 3' déplace ici la seconde série de n lingots L'1 à L'n de la droite vers la gauche, le plan incliné 2' étant orienté de façon opposé au plan incliné 2, mais il serait tout à fait possible de prévoir deux dispositifs d'alimentation identiques en tous points pour chaque moitié de la zone T.

On constate que dans ce mode de réalisation, il est possible d'optimiser la taille des lingots en déterminant leur largeur en fonction de la largeur de la zone T.

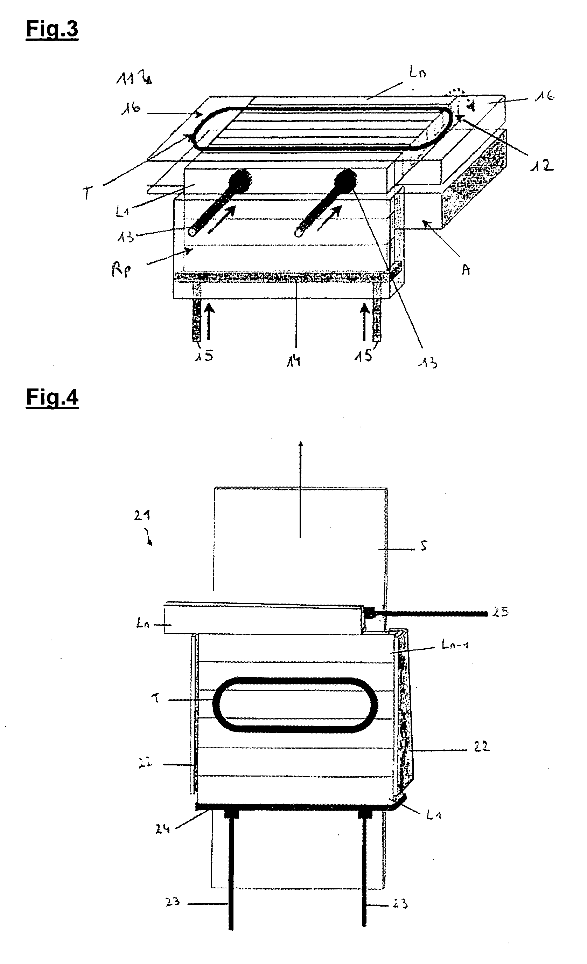

Dans un deuxième mode de réalisation, tel que représenté en figure 3, on peut voir un dispositif d'alimentation 11, comprenant de façon similaire au premier mode de réalisation, un plan incliné 12 portant une série de n lingots L1 à Ln s'étendant transversalement par rapport au substrat en défilement dans un plan horizontal (non représenté). L'environnement du dispositif d'alimentation 11 est identique à celui décrit pour la figure 2.

Le lingot L1 est déplacé par l'action des pistons 13 qui permettent de faire avancer les lingots L1 à Ln sur le plan incliné 12 jusqu'à tomber par gravité dans un bac de récupération (non représenté) placé sous la seconde extrémité du plan incliné 12.

Le rechargement en lingots se fait par une plaque 14 mise en mouvement par deux pistons 15, qui supporte un empilement de p lingots R1 à Rp et fonctionne de la même manière que le dispositif correspondant de la figure 2. De part et d'autre des lingots L1 à Ln, sont prévues deux guides latéraux 16 en tungstène qui maintiennent ces lingots L1 à Ln bien alignés.

On constate également que ce mode de réalisation de l'installation selon l'invention permet de s'adapter facilement à différentes largeurs de substrat à revêtir. En effet, il suffit de modifier la largeur des lingots et l'écartement des pièces 16 pour obtenir un dispositif présentant la largeur exactement nécessaire au revêtement en cours.

Dans un troisième mode de réalisation, tel que représenté en figure 4, on peut voir un dispositif d'alimentation 21, comprenant de façon similaire au premier mode de réalisation, deux plans inclinés 22 portant une série de n lingots L1 à Ln s'étendant transversalement par rapport au substrat S en défilement dans un plan vertical. Ces plans inclinés 22 présentent en outre des joues latérales assurant un bon alignement des lingots.

Le lingot L1 est déplacé par l'action de deux pistons verticaux 23 sur une plaque verticale 24, ce qui permet de faire avancer les lingots L1 à Ln le long des plans inclinés 22.

Lorsque le lingot supérieur Ln arrive au-delà de l'extrémité des plans inclinés 22, un piston horizontal 25 est actionné latéralement contre la face de ce lingot, qui peut ainsi être évacué sur le côté.

Ce mode de réalisation permet de revêtir le substrat de façon aisée en position verticale. Cette position permet en outre de réaliser très facilement un revêtement biface en plaçant un dispositif d'alimentation selon l'invention de chaque côté du substrat, le tout étant placé au sein d'une même enceinte à pression réduite.

### Essais

Des essais ont été réalisés à partir d'un montage conforme au premier mode de réalisation et d'un dispositif d'évaporation par plasma auto-induit (SIP). Des lingots de zinc pur ou de magnésium pur d'une épaisseur de 4 cm et d'une largeur de 10 cm ont été utilisés pour revêtir des bandes d'acier dont la largeur a varié entre 50 et 200 cm. Les bandes d'acier défilaient à 100 m/min sur un rouleau d'appui. On a également fait varier la vitesse d'évaporation des lingots.

La distance entre la surface supérieure des lingots et les bandes d'acier à revêtir a été maintenue à 5 cm et l'ouverture de la chambre, correspondant à la zone de dépôt dans le sens de défilement de la bande, a été réglée à 40 cm.

Dans tous les essais réalisés, on a déterminé la vitesse de défilement des lingots qu'il faut atteindre pour obtenir une épaisseur de dépôt de l'ordre de 1,5 µm.

Les résultats sont rassemblés dans les trois tableaux suivants :

| Matériau de revêtement | Zn | | | |
|---|---|---|---|---|
| Largeur bande (cm) | 50 | 100 | 150 | 200 |
| Largeur module SIP (cm) | 70 | 120 | 170 | 220 |
| Vitesse évaporation (g/cm2/s) | 0,01 | 0,01 | 0,01 | 0,01 |
| Vitesse défilement lingot (cm/min) | 2 | 3,4 | 4,8 | 6,2 |

| Matériau de revêtement | Zn | | | |
|---|---|---|---|---|
| Largeur bande (cm) | 50 | 100 | 150 | 200 |
| Largeur module SIP (cm) | 70 | 120 | 170 | 220 |
| Vitesse évaporation (g/cm2/s) | 0,02 | 0,02 | 0,02 | 0,02 |
| Vitesse défilement lingot (cm/min) | 4 | 6,8 | 9,6 | 12,4 |

| Matériau de revêtement | Mg | | | |
|---|---|---|---|---|
| Largeur bande (cm) | 50 | 100 | 150 | 200 |
| Largeur module SIP (cm) | 70 | 120 | 170 | 220 |
| Vitesse évaporation (g/cm2/s) | 0,002 | 0,002 | 0,002 | 0,002 |
| Vitesse défilement lingot (cm/min) | 1,6 | 2,8 | 4 | 5,2 |

On constate que la vitesse de défilement des lingots dépend essentiellement de la largeur de la bande à revêtir et de la vitesse d'évaporation de la matière de revêtement.

Des résultats analogues ont été obtenus à partir de montages conformes aux deuxième et troisième modes de réalisation.

D'une façon plus générale, on constate qu'une vitesse de défilement des lingots comprise entre 1 et 15 cm/min permet d'atteindre les cibles d'épaisseur de revêtements recherchées. Si l'on souhaite atteindre des épaisseurs de revêtement plus importantes, il suffit alors de faire passer le substrat devant une série de dispositifs de revêtements. Ainsi, pour obtenir une épaisseur de zinc de l'ordre de 7,5 µm dans les conditions d'évaporation indiquées dans les tableaux ci dessus, il faudra cinq dispositifs de revêtement.

Quel que soit le mode de réalisation adopté, l'invention présente également l'avantage de ne pas nécessiter l'usage de creusets en graphite, ce qui permet d'y réaliser facilement des dépôts en atmosphère réactive. Ceci peut notamment permettre de réaliser des dépôts d'oxydes, de nitrures, de sulfures, de fluorures métalliques, par exemple, et ceci à des vitesses de dépôt élevées.

Comme on a pu le voir au fil des descriptions de quelques modes de réalisation préférés de l'invention, le revêtement peut notamment être effectué lorsque le substrat défile de façon horizontale ou verticale. Il va de soi que le revêtement peut également être effectué pour toute position du substrat qui serait intermédiaire entre l'horizontale et la verticale.

## Revendications

1. Procédé de revêtement d'au moins une face d'un substrat en défilement, par évaporation sous vide d'une couche de métal ou d'alliage métallique susceptible d'être sublimé, selon lequel ledit métal ou alliage métallique est disposé en regard de ladite face du substrat sous la forme d'au moins deux lingots placés en contact l'un avec l'autre, la surface desdits lingots tournée vers ladite face du substrat étant maintenue parallèle au substrat et à une distance constante de celui-ci, au cours du revêtement.

2. Procédé de revêtement selon la revendication 1, dans lequel lesdits lingots de métal ou d'alliage métallique susceptible d'être sublimé sont déplacés simultanément, de façon continue ou séquentielle, afin de maintenir leurs surfaces tournées vers le substrat parallèles et à distance constante de celui-ci.

3. Procédé de revêtement selon la revendication 2, dans lequel lesdits lingots de métal ou d'alliage métallique susceptible d'être sublimé sont déplacés simultanément par translation.

4. Procédé de revêtement selon la revendication 3, dans lequel lesdits lingots sont déplacés simultanément par translation dans un plan parallèle au plan de défilement du substrat et dans une direction perpendiculaire à la direction de défilement du substrat, la surface des lingots opposée à celle tournée vers le substrat étant en contact avec un plan incliné.

5. Procédé de revêtement selon la revendication 3, dans lequel lesdits lingots sont déplacés simultanément par translation dans un plan parallèle au plan de défilement du substrat et dans une direction parallèle à la direction de défilement du substrat, la surface des lingots opposée à celle tournée vers le substrat étant en contact avec un plan incliné.

6. Procédé de revêtement selon l'une quelconque des revendications 1 à 5, dans lequel ledit substrat défile en position verticale, lesdits lingots étant empilés l'un sur l'autre.

7. Procédé de revêtement selon l'une quelconque des revendications 1 à 6, dans lequel on revêt ledit substrat sur ses deux faces par évaporation sous vide d'une couche de métal ou d'alliage métallique susceptible d'être sublimé, ledit métal ou alliage métallique étant disposé en regard de chaque face du substrat sous la forme d'au moins deux lingots placés en contact l'un avec l'autre, la surface desdits lingots tournée vers chaque face du substrat étant maintenue parallèle et à distance constante de ladite face du substrat, au cours du revêtement.

8. Procédé de revêtement selon la revendication 7, dans lequel ledit métal ou alliage métallique est identique pour chaque face du substrat.

9. Procédé de revêtement selon la revendication 7, dans lequel ledit métal ou alliage métallique est différent pour chaque face du substrat.

10. Procédé de revêtement selon l'une quelconque des revendications 1 à 9, dans lequel le procédé d'évaporation sous vide est un procédé de dépôt par évaporation par plasma auto-induit (SIP).

11. Procédé de revêtement selon l'une quelconque des revendications 1 à 10, dans lequel ledit métal ou alliage métallique est choisi parmi le zinc, le magnésium, le chrome, le manganèse, le silicium et leurs alliages.

12. Procédé selon la revendication 11, dans lequel ledit métal ou alliage métallique est le magnésium ou ses alliages.

13. Procédé selon l'une quelconque des revendications 1 à 12, dans lequel le dépôt par évaporation sous vide peut être effectué dans une atmosphère réactive.

14. Procédé selon l'une quelconque des revendications 1 à 13, dans lequel le substrat en défilement est une bande d'acier, éventuellement déjà revêtue au préalable.

15. Procédé selon la revendication 14, dans lequel le substrat en défilement est une bande d'acier préalablement revêtue de zinc ou d'alliage de zinc et sur laquelle on dépose une couche de magnésium ou d'alliage de magnésium.

16. installation de revêtement en continu d'un substrat (S) sur au moins une de ses faces par une couche d'un métal ou d'un alliage métallique susceptible d'être sublimé, comprenant une enceinte sous vide contenant :
- un dispositif de revêtement par évaporation sous vide,
- des moyens de défilement dudit substrat (S) au sein du dispositif de revêtement,
- un dispositif d'alimentation (1, 11, 21) en métal ou alliage métallique du dispositif de revêtement, ledit métal ou alliage métallique se présentant sous la forme de lingots (L1, ..., Ln, L'1, ..., L'n) et comprenant des moyens permettant de maintenir lesdits lingots (L1, ..., Ln, L'1, ..., L'n) en contact les uns avec les autres et de maintenir la surface desdits lingots (L1, ..., Ln, L'1, ..., L'n) tournée vers la face à revêtir du substrat (S), parallèle et à distance constante dudit substrat (S).

17. Installation de revêtement selon la revendication 16, dans laquelle ledit dispositif d'alimentation (1, 11, 21) comprend des moyens permettant de déplacer simultanément lesdits lingots (L1, ..., Ln, L'1, ..., L'n) de façon séquentielle ou continue afin de maintenir leurs surfaces tournées vers le substrat (S) parallèles et à distance constante de celui-ci.

18. Installation selon la revendication 17, dans laquelle ledit dispositif d'alimentation (11) comprend au moins un plan incliné (2, 2') avec lequel lesdits lingots (L1, ..., Ln, L'1, ..., L'n) sont en contact par leur face opposée à celle tournée vers ledit substrat (S), lesdits moyens de déplacement des lingots (L1, ..., Ln, L'1, ..., L'n) permettant de les déplacer par translation dans un plan parallèle au plan de défilement du substrat (S) et dans une direction perpendiculaire à la direction de défilement du substrat (S) et ledit plan incliné (2, 2') présentant une inclinaison augmentant dans la direction de déplacement desdits lingots (L1, ..., Ln, L'1, ..., L'n).

19. Installation selon la revendication 18, dans laquelle lesdits moyens de déplacement des lingots (L1, ..., Ln, L'1, ..., L'n) sont constitués par au moins un piston (3, 3') agissant sur un premier lingot (L1, L'1) en contact avec une première extrémité dudit plan incliné (2, 2'), et s'étendant transversalement par rapport au substrat (S), ledit premier lingot (L1, L'1) agissant à son tour sur les lingots (L2, ..., Ln, L'2, ..., L'n) le précédant sur ledit plan incliné (2, 2') jusqu'à sa seconde extrémité.

20. Installation selon la revendication 19, comprenant un premier plan incliné (2) muni de lingots (L1, ..., Ln) et d'un premier piston (3) agissant sur le premier lingot (L1) en contact avec la première extrémité dudit premier plan incliné (2) et un second plan (2') incliné muni de lingots (L'1, ..., L'n) et d'un second piston (3') agissant sur le premier lingot (L'1) en contact avec la première extrémité dudit second plan incliné (3'), lesdits pistons (3, 3') pouvant agir dans la même direction ou dans des directions contraires.

21. Installation selon la revendication 20, comprenant deux bacs (4) de récupération par gravité des lingots usagés (U), placés sous chaque seconde extrémité desdits plans inclinés (2, 2').

22. Installation selon la revendication 17, dans laquelle ledit dispositif d'alimentation (11, 21) comprend au moins un plan incliné (12, 22) avec lequel lesdits lingots (L1, ..., Ln) sont en contact par leur face opposée à celle tournée vers ledit substrat (S), lesdits moyens de déplacement des lingots permettant de les déplacer par translation dans un plan parallèle au plan de défilement du substrat (S) et dans une direction parallèle à la direction de défilement du substrat (S) et ledit plan incliné (12, 22) présentant une inclinaison augmentant dans la direction de déplacement desdits lingots (L1, ..., Ln).

23. Installation selon la revendication 22, dans laquelle lesdits moyens de déplacement des lingots (L1, ..., Ln) sont constitués par au moins un piston (13, 23) agissant sur un premier lingot (L1) en contact avec une première extrémité dudit plan incliné (12, 22), et s'étendant longitudinalement par rapport au substrat (S), ledit premier lingot (L1) agissant à son tour sur les lingots (L2, ..., Ln) le précédant sur ledit plan incliné (12, 22) jusqu'à sa seconde extrémité.

24. Installation selon la revendication 23, comprenant un bac de récupération par gravité des lingots usagés, placé sous ladite seconde extrémité du plan incliné (12, 22).

25. Installation selon l'une quelconque des revendications 22 à 25, dans laquelle le substrat (S) défile en position verticale, ledit dispositif d'alimentation (21) comprenant au moins une plaque verticale (24) sur laquelle sont empilés lesdits lingots (L1, ..., Ln) et qui est en contact avec au moins un piston vertical (23).

26. Installation selon l'une quelconque des revendications 16 à 25, comprenant un dispositif d'alimentation (1, 11, 21) en regard de chaque face dudit substrat (S), chaque dispositif d'alimentation (1, 11, 21) pouvant contenir un métal ou un alliage métallique identique ou différent, ainsi qu'un dispositif d'évaporation sous vide en regard de chaque face dudit substrat (S), l'ensemble étant placé au sein d'une même enceinte sous vide.

27. Installation selon l'une quelconque des revendications 16 à 26, comprenant des moyens d'introduction d'une atmosphère réactive au sein de ladite enceinte sous vide.

28. Installation selon l'une quelconque des revendications 16 à 27, dans laquelle ledit ou lesdits dispositifs d'évaporation sous vide sont des dispositifs de dépôt par évaporation par plasma auto-induit (SIP).

29. Installation selon l'une quelconque des revendications 16 à 28, dans laquelle lesdits lingots (L1, ..., Ln, L'1, ..., L'n) de métal ou d'alliage métallique sont choisis parmi le zinc, le magnésium, le chrome, le manganèse et le silicium ou leurs alliages.

30. Dispositif d'alimentation (1, 11, 21) en métal ou alliage métallique d'une installation de dépôt par revêtement sous vide, tel que défini dans l'une quelconque des revendications 16 à 29.
